# EUROPEAN PATENT APPLICATION

(11) **EP 4 761 029 A1**
(43) Date of publication of application: **17.06.2026**
(21) Application number: 25220466.4
(22) Date of filing: 03.12.2025
(51) Int. Cl.: H02H 3/08, H02H 3/093

(54) **OVERCURRENT PROTECTION CIRCUIT AND BATTERY MODULE INCLUDING THE SAME**

(30) Priority: 10.12.2024 KR 20240183136
(71) Applicant: SAMSUNG SDI CO., LTD., Yongin-si, Gyeonggi-do 17084 (KR)
(72) Inventor: CHO, Kyusung, 17084 Yongin-si, Gyeonggi-do (KR)
(74) Representative: Gulde & Partner

(57) **Abstract**

The present disclosure is related to an overcurrent protection circuit (100). An overcurrent protection circuit (100) includes an overcurrent protection unit (100A) to which a current measured by a current sensor (20) connected to a power source is input, and configured to increase an input voltage value (Vi) according to an input of the current over time, step-up the input voltage value (Vi) within a predetermined range in response to the input voltage value (Vi) exceeding a reference voltage value (Vref), and output an output voltage value (Vo) at a first level, and an output unit (150) connected to the overcurrent protection unit (100A) and configured to transmit the output voltage value (Vo) to a switch (30, 30A, 30B, 30C) connected between the power source and a load (60A, 60B, 60C).

## Description

### BACKGROUND

### 1. Field

The present disclosure relates to an overcurrent protection circuit and a battery module including the same.

### 2. Description of the Related Art

In control devices or power circuits included in automobiles, smartphones, etc., a circuit is applied to prevent overcurrent by measuring a flowing current while supplying or controlling the current.

As one of conventional technologies, it is known in the field that a controller detects a current value and blocks a power in the case of occurrence of overcurrent during the operation of a control device. As another form of conventional technologies, in the cases of a board consisting of only hardware without a controller or a sub-board capable of only communicating with a controller, a hardware circuit blocks the power.

However, in the conventional technologies, the power is blocked in the cases of temporary overload, noise, short circuits, etc. rather than continuous overcurrent, which cause problems in system operations. Therefore, it is desirable to provide a method for solving the herein-described issues.

The herein information disclosed in this Background section is for enhancement of understanding of the background of the present disclosure, and therefore, it may contain information that does not constitute related (or prior) art.

### SUMMARY

The invention is defined by the appended claims. The description that follows is subjected to this limitation. Any disclosure lying outside the scope of said claims is only intended for illustrative as well as comparative purposes.

According to embodiments, there is provided an overcurrent protection circuit for corresponding to overcurrent by using a simple hardware structure and a battery module including the same.

According to embodiments, there is provided an overcurrent protection circuit for maintaining a power operation in the case of temporary overcurrent while protecting a circuit from continuous overcurrent through switch control, and a battery module including the same.

According to yet embodiments, there is provided a protection circuit that effectively corresponds to overcurrent when a controller is included, and a battery module including the same.

However, the technical problem to be solved by the present disclosure is not limited to the problems described herein, and other problems not mentioned herein, and aspects and features of the present disclosure that would address such problems, will be clearly understood by those skilled in the art from the description of the present disclosure herein.

According to embodiments of the present disclosure, there is provided an overcurrent protection circuit, including an overcurrent protection unit to which a current measured by a current sensor connected to a power source is input, and configured to increase an input voltage value according to an input of the current (e. g. an input of the current measured by the current sensor) over time, step-up the input voltage value within a predetermined range in response to the input voltage value exceeding a reference voltage value, and output an output voltage value at a first level, and an output unit connected to the overcurrent protection unit and configured to transmit the output voltage value to a switch connected between the power source and a load.

The input voltage value and the predetermined threshold value (reference voltage value) may be compared. When the input voltage value reaches and/or exceeds the predetermined threshold value, the input voltage is increased in a step, i.e., it is assigned a new value.

The output voltage value at a first level may be output when the input voltage value exceeds the reference voltage value and when the input voltage is increased in a step.

The output unit may be configured to receive the output voltage value output from the overcurrent protection unit.

In other words, the overcurrent protection unit may be configured to output an output voltage value related to opening and closing of the switch. The output voltage value related to opening and closing of the switch may be at a first level (opening) and/or at a second level (closing).

The output voltage value may be related to opening and closing of the switch (in other words configured to open and close the switch).

The first level may correspond to a voltage value configured to open the switch.

The second level may correspond to a voltage value configured to close the switch.

Conventionally, for example in automobiles as well as in all control devices or power circuits, protection circuits that measure the current flow during power supply or control operations and shut off the circuit in the event of overcurrent have been used. In the case of boards composed essentially of hardware (HW) without an MCU, or sub-boards that can only communicate with an MCU, it has been typical for the HW circuit itself to perform the power shut-off. However, in such systems, even temporary overloads or short circuits can result in immediate shut-off, leading to operational issues in the system. The present disclosure prevents or at least reduces the influence of temporary overloads or short circuits.

According to embodiments of the present disclosure, the overcurrent protection unit may include a comparator comprising a first input terminal to which the reference voltage value is applied, a second input terminal to which the input voltage value is applied, and an output terminal that outputs the output voltage value related to opening and closing of the switch (e. g. the output voltage value at the first level and/or at the second level) based on the reference input value (e. g. the reference voltage value) and the input voltage value (e. g. based on a comparison of the reference input value and the input voltage value).

According to embodiments of the present disclosure, the comparator may be configured to output the output voltage value at the first level to open the switch in response to the input voltage value being higher than the reference voltage value (or being the same as or being higher than the reference voltage value), and output an output voltage value at a second level to close the switch in response to the input voltage value being lower than the reference voltage value.

According to embodiments of the present disclosure, the overcurrent protection unit may further include an integration circuit configured to delay a rise of the input voltage value according to the input of the current.

According to embodiments of the present disclosure, the overcurrent protection unit may further include an integration circuit including a resistor and a capacitor connected in parallel with the second input terminal and the output terminal of the comparator, and configured to delay a rise of the input voltage value according to the input of the current.

According to embodiments of the present disclosure, the overcurrent protection unit may further include a latch circuit connected to the second input terminal and the output terminal of the comparator, and configured to maintain the output voltage value at the first level during a predetermined period of time based on the output voltage value, the input voltage value, and the reference voltage value.

According to embodiments of the present disclosure, the overcurrent protection unit may further include a latch circuit connected to the second input terminal and the output terminal of the comparator, and including a resistor, a capacitor, and a transistor.

According to embodiments of the present disclosure, the latch circuit may be configured to maintain the output voltage value at the first level during a predetermined period of time based on the output voltage value, the input voltage value, and the reference voltage value.

According to embodiments of the present disclosure, the transistor may be turned on after a first time elapses after the output voltage value at the first level is output to the output terminal, wherein the input voltage value is lower than the reference voltage value after a second time elapses after the transistor is turned on, and wherein the predetermined period of time is a sum of the first time and the second time.

According to embodiments of the present disclosure, the comparator may be configured to output an output voltage value at the second level to close the switch in response to the input voltage value being lower than the reference voltage value after the second time elapses.

According to embodiments of the present disclosure, the overcurrent protection unit may be configured to step down the input voltage value within a predetermined range in response to the input voltage value being lower than the reference voltage value after the second time elapses.

According to embodiments of the present disclosure, a collector of the transistor may be connected to the second input terminal, wherein a base of the transistor is connected to one end of the resistor and the capacitor, and wherein the other end of the resistor is connected to the output terminal.

According to embodiments of the present disclosure, the first input terminal may be connected to the other end of a first resistor, one end of which is connected to a ground, and to the other end of a second resistor, one end of which is connected to a common collector voltage source, and wherein the reference voltage value is determined based on the first resistor and the second resistor.

According to embodiments of the present disclosure, there is provided a battery module including a battery, a switch connected between the battery and a load, a current sensor connected to the battery, and an overcurrent protection circuit connected to the current sensor and configured to output an output voltage value related to opening and closing of the switch based on a current measured by the current sensor, wherein the overcurrent protection circuit comprises an overcurrent protection unit configured to increase an input voltage value according to an input of the current (e. g. the current measured by the current sensor) over time, step-up the input voltage value with a predetermined range in response to the input voltage value exceeding a reference voltage value, and output an output voltage value at a first level.

The current sensor may be configured to measure a current and to input the current to the overcurrent protection unit.

In other words, the overcurrent protection circuit connected to the current sensor may be configured to output an output voltage value an output voltage value at a first level (e. g. related to opening of the switch) and/or at a second level (e. g. related to closing of the switch).

The overcurrent protection unit may be configured to have the current measured by the current sensor input into it.

The overcurrent protection circuit may include an output unit connected to the overcurrent protection unit and configured to transmit the output voltage value to the switch and/or to the driving circuit.

According to embodiments of the present disclosure, the battery module may further include a driving circuit connected to the switch (configured) to open and close the switch.

According to embodiments of the present disclosure, the driving circuit may be configured to, obtain the output voltage value from the overcurrent protection circuit (e. g. from the output unit), open the switch in response to the output voltage value at the first level, and close the switch in response to an output voltage value at a second level.

According to embodiments of the present disclosure, the battery module may further include a controller configured to control the driving circuit, and an OR gate including an input terminal connected to the controller and the overcurrent protection circuit and an output terminal connected to the driving circuit.

According to embodiments of the present disclosure, the driving circuit may be configured to obtain the output voltage value at the first level from the overcurrent protection circuit or open the switch in response to receiving an open control signal from the controller.

According to embodiments of the present disclosure, the battery module may further include a controller configured to obtain the output voltage value from the overcurrent protection circuit, and control the driving circuit based on the output voltage value.

According to embodiments of the present disclosure, the overcurrent protection unit may include a comparator comprising, a first input terminal to which the reference voltage value is applied, a second input terminal to which the input voltage value is applied, and an output terminal configured to output the output voltage value related to opening and closing of the switch based on the reference input value (e. g. the reference voltage value) and the input voltage value.

According to embodiments of the present disclosure, the overcurrent protection unit may further include an integration circuit including a resistor and a capacitor connected in parallel with the second input terminal and the output terminal of the comparator, and configured to delay a rise of the input voltage value according to the input of the current.

According to embodiments of the present disclosure, the overcurrent protection unit may further include a latch circuit connected to the second input terminal and the output terminal of the comparator, and including a resistor, a capacitor, and a transistor, wherein the latch circuit is configured to maintain an output voltage value at the first level during a predetermined period of time based on the output voltage value, the input voltage value, and the reference voltage value.

According to embodiments of the present disclosure, the transistor may be turned on after a first time elapses after the output voltage value at the first level is output to the output terminal, wherein the input voltage value is lower than the reference voltage value after a second time elapses after the transistor is turned on, and wherein the predetermined period of time is a sum of the first time and the second time.

According to embodiments, an overcurrent protection circuit and a battery module are provided to effectively correspond to a continuous overcurrent without being overly sensitive to temporary overloads or short-circuits in the absence of a complex hardware structure.

According to embodiments of the present disclosure, there is provided a method of manufacturing an overcurrent protection circuit, including providing an overcurrent protection unit to which a current measured by a current sensor connected to a power source is input, and configured to increase an input voltage value according to an input of the current over time, step-up the input voltage value within a predetermined range in response to the input voltage value exceeding a reference voltage value, and output an output voltage value at a first level, and providing an output unit connected to the overcurrent protection unit and configured to transmit the output voltage value to a switch connected between the power source and a load.

According to the disclosure, when overcurrent is detected, the system may not immediately shut off the circuit. Instead, it may integrate the current over time, introducing a preset delay. This may ensure that only sustained and continuous overcurrent - not noise or momentary spikes - will trigger the shut-off.

Furthermore, after detection of sustained and continuous overcurrent, a latch operation may immediately be executed to maintain the off state, and the circuit may automatically turn back on after a preset period, thereby preventing damage to the switch.

In other words, a compact circuit composed entirely of pure hardware (without an MCU) may be provided that can turn the system back on after a certain period. It is an intelligent circuit that does not respond to transient overloads or noise but operates only in the case of continuous overload.

Strong hysteresis behavior may provide robust protection against chattering caused by ripple or noise.

By using an integration circuit, protection operation in response to overcurrent may be delayed without an MCU, allowing normal operation without shut-off in the case of transient overcurrent.

The delay time may be adjusted, and due to the long delay, there is minimal damage to the switch even during repeated on/off operations.

The circuit is composed of simple hardware and has a compact design, enabling cost reduction.

However, aspects and features of the present disclosure are not limited to those described herein, and other aspects and features not mentioned will be clearly understood by a person skilled in the art from the detailed description, described herein.

### BRIEF DESCRIPTION OF THE DRAWINGS

The following drawings attached to this specification illustrate embodiments of the present disclosure, and further describe aspects and features of the present disclosure together with the detailed description of the present disclosure. Thus, the present disclosure should not be construed as being limited to the drawings.
FIG. 1 is a schematic view illustrated to explain an overcurrent protection circuit according to embodiments of the present disclosure;
FIG. 2 is a detailed view illustrating an overcurrent protection circuit according to embodiments of the present disclosure;
FIG. 3 is a view illustrating a voltage waveform of an overcurrent protection circuit according to embodiments of the present disclosure;
FIG. 4 is a view illustrating a simulated voltage waveform of an overcurrent protection circuit according to embodiments of the present disclosure;
FIG. 5 is a view illustrating a battery module according to embodiments of the present disclosure;
FIG. 6 is a view illustrating a battery module according to embodiments of the present disclosure; and
FIG. 7 is a view illustrating a battery module according to embodiments of the present disclosure.

### DETAILED DESCRIPTION

Hereinafter, embodiments of the present disclosure will be described, in detail, with reference to the accompanying drawings. The terms or words used in the present specification and claims are not to be limitedly interpreted as general or dictionary meanings and should be interpreted as meanings and concepts that are consistent with the technical idea of the present disclosure on the basis of the principle that an inventor can be his/her own lexicographer to appropriately define concepts of terms to describe his/her disclosure in the best way.

The embodiments described in this specification and the configurations shown in the drawings are only some of the embodiments of the present disclosure and do not represent all of the technical aspects, and features of the present disclosure. Accordingly, it should be understood that there may be various modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed herein could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein. All such ranges are intended to be inherently described in this specification such that amending to expressly recite any such subranges would comply with the requirements of 35 U.S.C. § 112(a) and 35 U.S.C. § 132(a).

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

Arranging an arbitrary element "above (or below)" or "on (under)" another element may mean that the arbitrary element may be disposed in contact with the upper (or lower) surface of the element, and another element may also be interposed between the element and the arbitrary element disposed on (or under) the element.

In addition, it will be understood that when a component is referred to as being "linked," "coupled," or "connected" to another component, the elements may be directly "coupled," "linked" or "connected" to each other, or another component may be "interposed" between the components".

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

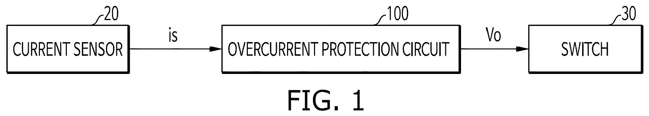

FIG. 1 is a schematic view illustrated to explain an overcurrent protection circuit 100 according to embodiments of the present disclosure.

The overcurrent protection circuit 100 may monitor overcurrent and protect a circuit by receiving a current (is) measured by a current sensor 20 connected to a power source. According to the present disclosure, the feature of receiving the current (is) from the current sensor 20 may indicate that a voltage corresponding to the current (is) may be applied from the current sensor 20 (e..g using a shunt resistor). The power source may be a battery, a secondary battery, etc. that supplies power to the load.

The overcurrent protection circuit 100 may output an output voltage value Vo, which is related to opening and closing of a switch 30 connected between the load that receives power and the power source according to the current (is) input from the current sensor 20, to the switch 30. The switch 30 may be connected between the power source and the load. The switch 30 may operate according to the output voltage value Vo related to opening or closing, which is obtained from the current protection circuit 100. According to some embodiments of the present disclosure, one or more of components may be disposed between the switch 30 and the overcurrent protection circuit 100. In this case, the current (is) input from the current sensor 20 or the voltage applied from the current sensor 20 may be transmitted to the overcurrent protection circuit 200 through one or more components.

The overcurrent protection circuit 100 may be applied to an overcurrent protection device, a battery module, a battery management system, a relay system, etc., but also may be applied to various devices and systems that protect circuits by monitoring overcurrent. The overcurrent protection device or the battery management system may refer to the configuration that includes the overcurrent protection circuit 100, the current sensor 20, and the switch 30. The battery module may refer to the configuration that includes a battery, a switch, a current sensor, an overcurrent protection circuit, a driving circuit, and a controller.

The overcurrent protection circuit 100 may open a switch by monitoring a continuous overcurrent that causes damage to the switch 30 or the system. The overcurrent protection circuit 100 may not open the switch for temporary noise, short-circuit, ripple current, etc. but may remain inactive for a predetermined period of time. Accordingly, complete power shutdown may be prevented due to overcurrent, which ensures smooth system operation.

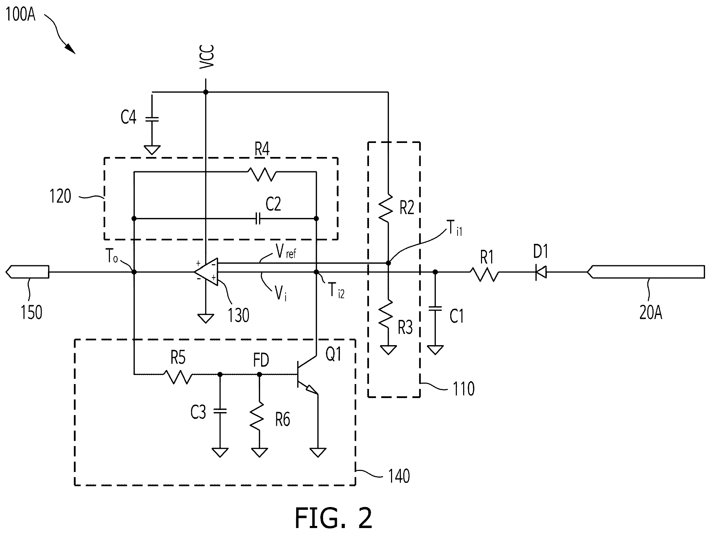

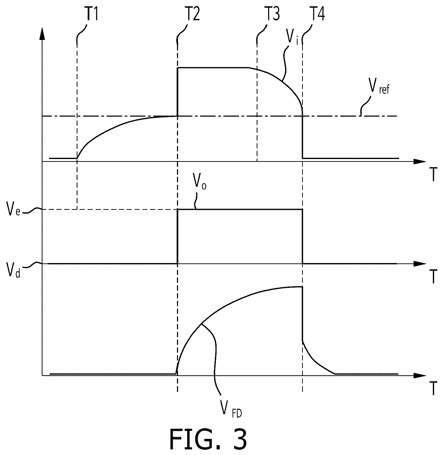

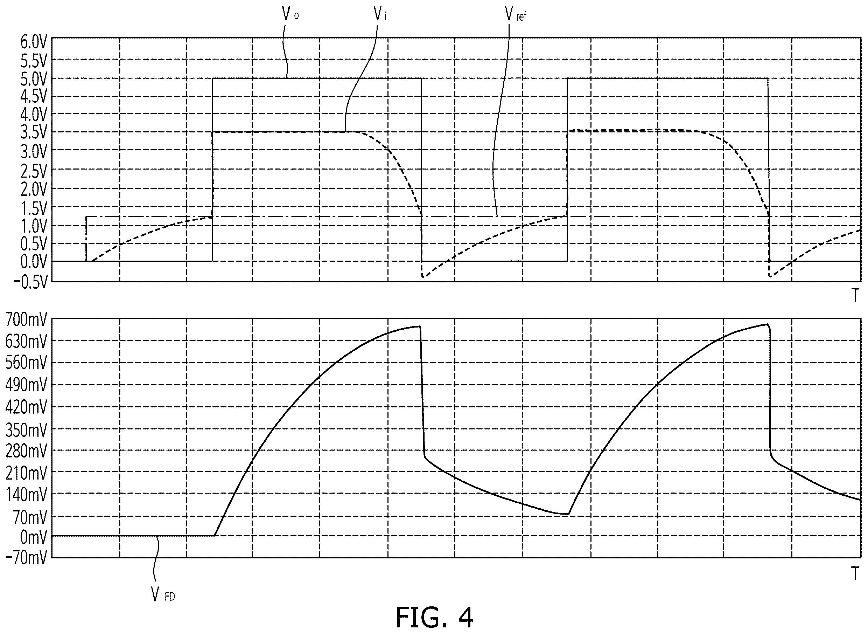

Referring to FIG. 2 to FIG. 4, the configuration and operation of the overcurrent protection circuit 100 according to embodiments will be described in detail. FIG. 2 is a detailed view illustrating the overcurrent protection circuit 100 according to embodiments, FIG. 3 is a view illustrating a voltage waveform of the overcurrent protection circuit 100 according to embodiments, and FIG. 4 is a view illustrating simulation of a voltage waveform of the overcurrent protection circuit 100 according to embodiments.

The overcurrent protection circuit 100 may include an overcurrent protection unit 100A and an output unit (or an output terminal) 150. The current of the current sensor 20 connected to the power source may be input to the overcurrent protection unit 100A through a current output terminal 20A. The output unit 150 may be connected to the overcurrent protection unit 100A and may transmit the output voltage value of the overcurrent protection unit 100A to the switch 30.

The overcurrent protection unit 100A may include a first diode D1. A current transmitted through the current output terminal 20A (i.e., the current measured by the current sensor 20) may be input to the first diode D1. The first diode D1 may be a switching diode and may have a short recovery time in the nanosecond range to support high-speed switching. The first diode D1 may allow the current to flow in one direction, and prevent the current from flowing in the opposite direction (e.g., in the direction of the current sensor output terminal 20A).

The one end of the first diode D1 may be connected to the current output terminal 20A, and the other end may be connected to one end of a first resistor R1. The other end of the first resistor R1 may be connected to a first capacitor C1. According to embodiments, the first resistor R1 may have a capacitance of 1 (one) kiloohm and the first capacitor C1 may have a capacitance of 4.7 microfarads, but the embodiment is not limited thereto.

The overcurrent protection unit 100A may include a comparator 130. The comparator 130 may include a first input terminal Ti1 to which a reference voltage value is applied, and a second input terminal Ti2 to which an input voltage value is applied. The comparator 130 may include an output terminal To that outputs an output voltage value related to opening and closing of the switch 30 based on a reference input value (e. g. the reference voltage value Vref) and an input voltage value.

The comparator 130, when an input voltage value Vi is higher than a reference voltage value Vref, may output an output voltage value Vo at the first level (e.g., a high level) for opening the switch 30. The comparator 130, when the input voltage value Vi is lower than the reference voltage value Vref, may output an output voltage value at the second level (e.g., a low level) for closing the switch 30. The comparator 130 may amplify the voltage difference between input terminals Ti1 and Ti2, and may include a differential input structure having a non-inverting input terminal and an inverting input terminal. According to embodiments, a reference voltage value may be 1.2 V, but may vary depending on circuit configurations.

A voltage divider circuit 110 may set a reference voltage. The first input terminal Ti1 may be connected to the other end of a third resistor R3 (here, this resistor is referred to as the third resistor only to distinguish it from the other resistors in the present embodiment; in the previous description regarding the determination of the reference voltage value based on the first resistor and the second resistor, this resistor is therefore referred to as the first resistor to distinguish it from the second resistor), one end of which is connected to a ground, and the other end of a second resistor R2, one end of which is connected to a common collector voltage source VCC. The reference voltage value Vref may be determined by the second resistor R2 and the third resistor R3. According to embodiments, the second resistor R2 may be 10 kilohm and the third resistor R3 may be 3.3 kilohm, but may vary depending on circuit configurations.

The overcurrent protection unit 100A may further include an integration circuit 120. The integration circuit 120 may include a fourth resistor R4 and a second capacitor C2 connected in parallel with the second input terminal Ti2 and the output terminal To. The integration circuit 120 may include the fourth resistor R4 and the second capacitor C2 connected in parallel to delay the rise of the input voltage value Vi in response to the input of the current. The degree of delay in the rise of the input voltage value Vi may be determined by the resistance of the fourth resistor R4 and the capacitance of the second capacitor C2.

The integration circuit 120 may gradually increase the input voltage value Vi input through the second input terminal Ti2 based on integral operation. The integration circuit 120 may prevent the voltage from swiftly rising by gradually increasing the voltage in the second capacitor C2. Even when a temporary overcurrent flows, the overcurrent protection circuit 100 may not open the switch to stop the operation of the system, but may open the switch 30 after a predetermined period of time (e.g., a time required for an input voltage value to be the same as or higher than the reference voltage value). Accordingly, the operation efficiency and the stability of the device or system (e.g., a battery module and an electronic device including the same) including the overcurrent protection circuit 100 may be improved. The integration circuit 120 according to embodiments may perform an integral operation for 18 msec, but the embodiment is not limited thereto.

The overcurrent protection unit 100A may increase the input voltage value Vi according to the input of the current over time by using the integration circuit 120. The overcurrent protection unit 100A may step up the input voltage value Vi within a predetermined range when the input voltage value Vi exceeds the reference voltage value Vref, and output the output voltage value Vo at the first level. The comparator 130 may output the output voltage value Vo at the first level (high level) related to the opening of the switch 30 through the output terminal To. Accordingly, the integral characteristic may be removed due to the coupling characteristic of the second capacitor C2, and the input voltage value may be stepped-up within a predetermined range. The predetermined range may be determined according to the input voltage value Vi. The step-up of the input voltage value Vi may be referred to as a hysteresis operation. Due to the increase of the input voltage value Vi, chattering caused by ripple current or noise may be prevented, and the overcurrent protection circuit 100 may stably operate.

The overcurrent protection circuit 100 may increase the input voltage value Vi through a current sensor 20 in a current path of a switch connected between the power source and the load supplied with power from the power source. The overcurrent protection circuit 100 may step up the input voltage value Vi within a predetermined range when the input voltage value Vi exceeds the reference voltage value Vref to open and close the switch 30 automatically without a controller such as MCU. In addition, the overcurrent protection circuit 100 may not open the switch 30 for a temporary overcurrent (a ripple current, a current cased by noise (e.g., a current for several msec)), and may improve the stability through the hysteresis operation.

The overcurrent protection unit 100A may further include a latch circuit 140 connected to the second input terminal Ti2 and the output terminal To of the comparator 130, and including a fifth resistor R5, a third capacitor C3 and a transistor Q1.

A transistor Q1 collector of the latch circuit 140 may be connected to the second input terminal Ti2, and the base of the transistor Q1 may be connected to one end of the fifth resistor R5 and the third capacitor C3, and the other end of the fifth resistor R5 may be connected to the output terminal.

The latch circuit 140 may maintain an output voltage value Ve at the first level during a predetermined time based on the output voltage value Vo through the output terminal To of the comparator 130, the input voltage value Vi and the reference voltage value Vref.

When the overcurrent occurs and an open control signal is output through the comparator 130, the overcurrent protection circuit 100 may activate a latch function. As the latch function is activated, the opening status of the switch 30 may be maintained during a predetermined period of time. In this case, when a switch opening control signal is output through an output unit 150 from the comparator 130, the output voltage may be applied to the second input terminal Ti2 through the fourth resistor R4, and a voltage may be charged at the first capacitor C1. Impedance may change to infinity by the first diode D1 that prevents the current from flowing reversely, and the discharge may not occur, so that the comparator 130 may continuously output the opening control signal of the switch 30.

Referring to FIG. 3, a transistor Q1 of the latch circuit 140 may be turned on at T3 after a first time T3-T2 elapses after the output voltage value Vo at the first level is output at T2 to the output terminal To of the comparator 130. The input voltage value Vi may become lower than the reference voltage value Vref after a second time T4-T3 elapses after the transistor Q1 is turned on at T3. Predetermined times T2 to T4 during which the output voltage value Ve at the first level is maintained may be the sum of the first time T2 to T3 and the second time T3 to T4.

The comparator 130, when the input voltage value Vi is lower than the reference voltage value Vref after the second time elapses T4, may output an output voltage value Vd at the second level (e.g., a lower level) for closing the switch 30.

The overcurrent protection unit 100A, when the input voltage value Vi is lower than the reference voltage value Vref after the second time elapses T4, may step down an input voltage value within a predetermined range based on the hysteresis operation.

In a feedback terminal FD of the latch circuit 140, a voltage value VFD may rise for a predetermined period T2 to T4 and then step down after the second time T4.

Referring to FIG. 3, the overcurrent protection circuit 100 that represents a voltage waveform may be provided and during the temporary overcurrent, the problems may be solved in the cases of a comparative example (switch off) where overcurrent detection is remarked at a point where an input voltage value increases and an output voltage value rapidly increases to close a switch, and a comparative example (switch on) where the output voltage value increases and then rapidly decreases.

The input voltage value Vi applied to the second input terminal Ti2 of the comparator 130 may gradually increase by the integration circuit 120 in a first section (sections T1 to T2 of FIG. 3) when overcurrent is input. The input voltage value Vi may perform the hysteresis operation to step up at a point where the input voltage value Vi is higher than the reference voltage value Vref (T2 of FIG. 3).

The input voltage value Vi may maintain the stepped-up voltage value in a second section (sections T2 to T3 of FIG. 3) when the latch circuit 140 is driven, and then the transistor Q1 may reach a turn-on voltage value (e.g., 700 mV). After the transistor Q1 is turned on, the input voltage value Vi may gradually decrease in a third section (sections T3 to T4 of FIG. 3) and then may be stepped-down by performing a hysteresis operation when reaching the reference voltage value Vref.

According to embodiments, the input voltage value Vi corresponding to the overcurrent for simulation may be 3.5 V. The reference voltage value Vref may be set to 1.2 V. The output voltage value Vo that opens the switch 30 may be set to 5 V. The transistor Q1 may be turned on at 700 mV. As shown in FIG. 4, it is confirmed that the same voltage waveform is repeated due to the repeated input of the overcurrent during simulation.

The overcurrent protection circuit 100 may be installed in the battery module. Battery modules 10A to 10C according to various embodiments will be described herein.

In other words, the voltage Vin resulting from the current level output from the current sensor 20A is compared with a reference value (VRef) set by the second resistor R2 and the third resistor R3. When the detected current exceeds the preset VRef value, the comparator 130 outputs a high signal (first level) configured to turn off the switch 30.

During initial operation, the output of comparator 130 is low (second level), causing a significant time delay due to the values of the ratio between the first resistor R1 and the fourth resistor R4 as well as the ratio between the first capacitor C1 and the second capacitor C2, which results in a gradual voltage buildup (the main delay is caused by the combination of the first resistor R1 and the ratio between the first capacitor C1 and the second capacitor C2).

Once the voltage Vin exceeds the set VRef value, comparator 130 outputs a high signal (first level). At this point, due to the coupling characteristics of second capacitor C2, the integration behavior disappears and a sharp voltage rise occurs at the input terminal, exhibiting a strong hysteresis behavior. After that, the output voltage of the comparator 130 is fed back through the fourth resistor R4 to the input terminal and charges the first capacitor C1. However, due to the blocking effect of diode D1, the impedance becomes effectively infinite, preventing discharge and maintaining the high state.

Then, the output voltage begins to charge the fifth resistor R5 and the third capacitor C3, and after a certain charging time, if the voltage rises above the turn-on threshold of transistor Q1 (approximately 0.7 V), transistor Q1 is activated. This causes the input voltage to drop below the reference voltage, turning off the latch circuit 140.

When overcurrent occurs again, the operation is repeated from the beginning through the integration circuit.

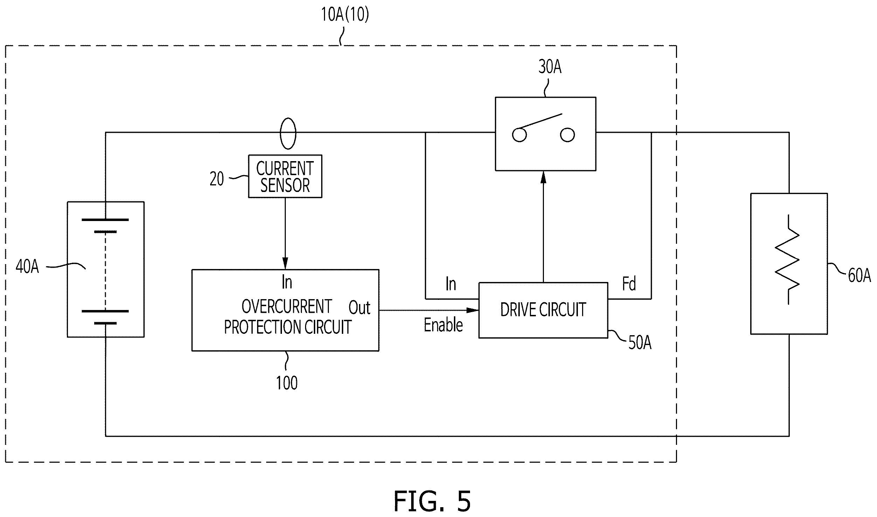

FIG. 5 is a view illustrating a battery module 10A according to embodiments.

The battery module 10A may include a battery 40A, a switch 30A connected between the battery 40A and a load 60A, a current sensor 20 connected to the battery 40A, and an overcurrent protection circuit 100 connected to the current sensor 20 and outputting an output voltage value related to opening and closing of the switch 30A based on the current measured by the current sensor, and a driving circuit 50A connected to the switch 30 for opening and closing the switch 30.

The battery 40A may include one or more battery cells, but the embodiment is not limited thereto. The battery cell may consist of a battery case, and an electrode assembly and electrolyte provided in the battery case. The electrode assembly and the electrolyte may react electrochemically to generate energy.

The current sensor 20 according to embodiments may be set to have a voltage ratio of one hundred to one, ten to one, etc., but the embodiment is not limited thereto.

The switch 30A according to embodiments may be embodied as a field effect transistor (FET) element, and the FET element may control the flow of current due to the voltage.

The overcurrent protection circuit 100 may increase the input voltage value according to the input current over time, step-up the input voltage value within a predetermined range when the input voltage value exceeds the reference voltage value, and may include an overcurrent protection unit that outputs an output voltage value at the first level.

The driving circuit 50A may include a pulse width modulation (PWM) driving circuit. The driving circuit 50A may open or close the switch 30 according to the output voltage value of the overcurrent protection circuit 100. The driving circuit 50A may include an input terminal and a feedback terminal.

The driving circuit 50A may obtain an output voltage value from the overcurrent protection circuit 100, open the switch 30A in response to the output voltage value at the first level, and close the switch 30A in response to the output voltage value at the second level.

The overcurrent protection unit 100A of the overcurrent protection circuit 100 may include the comparator 130 including a first input terminal to which a reference voltage value is applied, a second input terminal to which an input voltage value is applied, and an output terminal that outputs an output voltage value related to opening and closing of the switch 30A based on a reference input value (e. g. the reference voltage value) and an input voltage value.

The overcurrent protection unit 100A may include a resistor and a capacitor connected in parallel with the second input terminal and the output terminal of the comparator 130. The overcurrent protection unit 100A may further include the integration circuit 120 that delays the increase of the input voltage value according to the input of the current.

The overcurrent protection unit 100A may further include a latch circuit 140 connected to the second input terminal and the output terminal of the comparator 130 and including a resistor, a capacitor, and a transistor. The latch circuit 140 may maintain the output voltage value at the first level during a predetermined period of time based on an output voltage value, an input voltage value, and a reference voltage value.

The transistor of the latch circuit 140 may be turned on when the first time elapses after the output voltage value at the first level is output at the output terminal of the comparator 130. The input voltage value may be lower than a reference voltage value after the second time elapses after the transistor is turned on, and the predetermined period of time may be a sum of the first time and the second time.

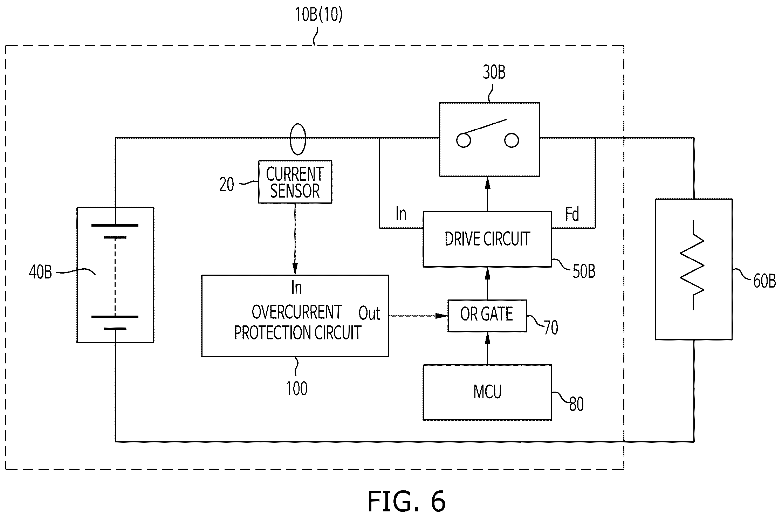

FIG. 6 is a view illustrating a battery module 10B according to embodiments of the present disclosure.

The battery module 10B, similar to the configuration of the battery module A 10 of FIG. 5, may include a battery 40B, a switch 30B connected between the battery 40B and a load 60B, a current sensor 20 connected to the battery 40B, an overcurrent protection circuit 100 that is connected to the current sensor 20 and outputs an output voltage value related to opening and closing of the switch 30B based on the current measured by the current sensor 20, and a driving circuit 50B connected to the switch 30B for opening and closing the switch 30B.

The battery module 10B may further include a microcontroller unit (MCU) 80 that controls the driving circuit 50B. The battery module 10B may further include an OR gate 70 including an input terminal connected to the MCU 80 and the overcurrent protection circuit 100, and an output terminal connected to the driving circuit 50B.

The driving circuit 50B may obtain an output voltage value at the first level from the overcurrent protection circuit 100, or open the switch 30 in response to receiving an open control signal from the MCU 80.

The overcurrent protection unit 100A of the overcurrent protection circuit 100 may include the comparator 130 including a first input terminal to which a reference voltage value is applied, a second input terminal to which an input voltage value is applied, and an output terminal that outputs an output voltage value related to opening and closing of the switch 30B based on a reference input value (e. g. the reference voltage value) and an input voltage value.

The overcurrent protection unit 100A may include a resistor and a capacitor connected in parallel with the second input terminal and the output terminal of the comparator 130. The overcurrent protection unit 100A may further include the integration circuit 120 that delays the increase of the input voltage value according to the input of the current.

The overcurrent protection unit 100A may be further include the latch circuit 140 connected to the second input terminal and the output terminal of the comparator 130 and including a resistor, a capacitor, and a transistor, and the latch circuit 140 may maintain the output voltage value at the first level during a predetermined period of time based on an output voltage value, an input voltage value, and a reference voltage value.

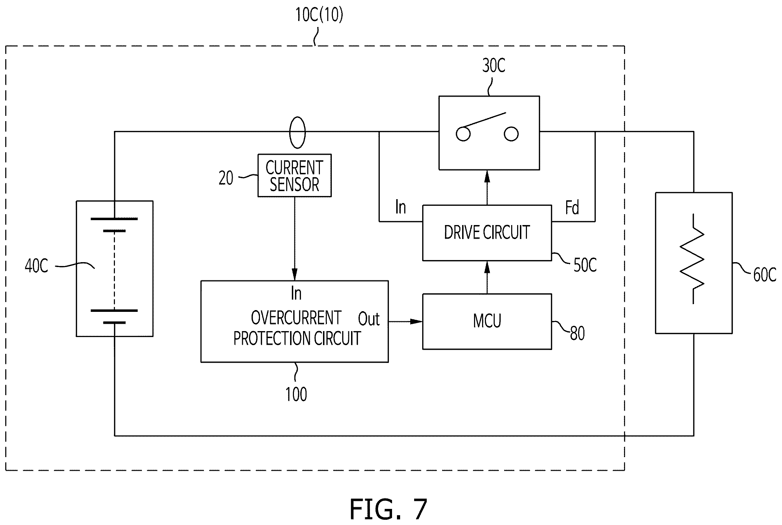

FIG. 7 is a view illustrating a battery module 10C according to embodiments.

The battery module 10C, similar to the battery module 10A illustrated in FIG. 5, may include a battery 40C, a switch 30C connected between the battery 40C and a load 60C, a current sensor 20 connected to the battery 40C, and an overcurrent protection circuit 100 that is connected to the current sensor 20 and outputs an output voltage value related to opening and closing of the switch 30C based on the current measured by the current sensor 20, and a driving circuit 50C connected to the switch 30c to open and close the switch 30C.

The battery module 10C may further include the MCU 80 that controls the driving circuit 50C. The MCU 80 may obtain an output voltage value for controlling the switch 30C from the overcurrent protection circuit 100 and control the driving circuit 50C based on the output voltage value.

The overcurrent protection circuit 100 may include a first input terminal to which a reference voltage value is applied, a second input terminal to which an input voltage value is applied, and an output terminal that outputs the output voltage value related to opening and closing of the switch 30A based on a reference input value (e. g. the reference voltage value) and an input voltage value.

The overcurrent protection unit 100A may include a resistor and capacitor connected in parallel with the second input terminal and the output terminal of the comparator 130, and may further include the integration circuit 120 that delays the increase of the input voltage value according to the input of the current.

The overcurrent protection unit 100A may further include the latch circuit 140 connected to the second input terminal and the output terminal of the comparator 130 and including a resistor, a capacitor, and a transistor. The latch circuit 140 may maintain the output voltage value at the first level during a predetermined period of time based on an output voltage value, an input voltage value, and a reference voltage value.

A battery module according to embodiments of the present disclosure may be applied to vehicles, mobile phones, and/or electronic devices of various forms.

Although the present disclosure has been described herein with respect to embodiments thereof, the present disclosure is not limited thereto. Various modifications and variations can be made thereto by those skilled in the art within the present disclosure and the scope of the appended claims.

## Claims

1. An overcurrent protection circuit (100), comprising:
an overcurrent protection unit (100A) configured to have a current measured by a current sensor (20) connected to a power source input into it, and configured to increase an input voltage value (Vi) according to an input of the current over time, step-up the input voltage value (Vi) within a predetermined range in response to the input voltage value (Vi) exceeding a reference voltage value (Vref), and output an output voltage value (Vo) at a first level; and
an output unit (150) connected to the overcurrent protection unit (100A) and configured to transmit the output voltage value (Vo) to a switch (30, 30A, 30B, 30C) connected between the power source and a load (60A, 60B, 60C).

2. The overcurrent protection circuit (100) as claimed in claim 1, wherein the overcurrent protection unit (100A) comprises a comparator (130) comprising:
a first input terminal (Ti1) configured to have the reference voltage value (Vref) applied thereto;
a second input terminal (Ti2) configured to have the input voltage value (Vi) applied thereto; and
an output terminal (To) configured to output the output voltage value related to opening and closing of the switch (30, 30A, 30B, 30C) based on the reference voltage value (Vref) and the input voltage value (Vi).

3. The overcurrent protection circuit (100) as claimed in claim 2, wherein the comparator (130) is configured to:
output the output voltage value (Vo) at the first level to open the switch (30, 30A, 30B, 30C) in response to the input voltage value (Vi) being higher than the reference voltage value (Vref), and
output an output voltage value (Vd) at a second level to close the switch (30, 30A, 30B, 30C) in response to the input voltage value (Vi) being lower than the reference voltage value (Vref).

4. The overcurrent protection circuit (100) as claimed in claim 2 or 3, wherein the overcurrent protection unit (100A) further comprises an integration circuit (120) including a resistor (R4) and a capacitor (C2) connected in parallel with the second input terminal (Ti2) and the output terminal (To) of the comparator (130), and configured to delay a rise of the input voltage value (Vi) according to the input of the current.

5. The overcurrent protection circuit (100) as claimed in any one of claims 2 to 4, wherein the overcurrent protection unit (100A) further comprises:
a latch circuit (140) connected to the second input terminal (Ti2) and the output terminal (To) of the comparator (130), and including a resistor (R5), a capacitor (C3), and a transistor (Q1),
wherein the latch circuit (140) is configured to maintain the output voltage value (Ve) at the first level during a predetermined period of time based on the output voltage value (Vo), the input voltage value (Vi), and the reference voltage value (Vref).

6. The overcurrent protection circuit (100) as claimed in claim 5, wherein the transistor (Q1) is configured to be turned on after a first time (T3-T2) elapses after the output voltage value (Vo) at the first level is output at the output terminal (To),
such that the input voltage value (Vi) is lower than the reference voltage value (Vref) after a second time (T4-T3) elapses after the transistor (Q1) is turned on, and
wherein the predetermined period of time is a sum of the first time (T3-T2) and the second time (T4-T3).

7. The overcurrent protection circuit (100) as claimed in claim 6, wherein the comparator (130) is configured to output an output voltage value (Vd) at a second level for closing the switch (30, 30A, 30B, 30C) in response to the input voltage value (Vi) being lower than the reference voltage value (Vref) after the second time (T4-T3) elapses.

8. The overcurrent protection circuit (100) as claimed in claim 6 or 7, wherein the overcurrent protection unit (100A) is configured to step down the input voltage value (Vi) within a predetermined range in response to the input voltage value (Vi) being lower than the reference voltage value (Vref) after the second time (T4-T3) elapses.

9. The overcurrent protection circuit (100) as claimed in any one of claims 5 to 8, wherein a collector of the transistor (Q1) is connected to the second input terminal (Ti2),
wherein a base of the transistor (Q1) is connected to one end of the resistor (R4) and the capacitor (C2), and
wherein the other end of the resistor (R4) is connected to the output terminal (To).

10. The overcurrent protection circuit (100) as claimed in any one of claims 2 to 9, wherein the first input terminal (Ti1) is connected to the other end of a first resistor (R3), one end of which is connected to a ground, and to the other end of a second resistor (R2), one end of which is connected to a common collector voltage source (VCC), and
wherein the reference voltage value (Vref) is determined based on the first resistor (R4) and the second resistor (R4).

11. A battery module (10A, 10B, 10C), comprising:
a battery (40A, 40B, 40C);
a switch (30, 30A, 30B, 30C) connectable between the battery (40A, 40B, 40C) and a load (60A, 60B, 60C);
a current sensor (20) connected to the battery (40A, 40B, 40C); and
an overcurrent protection circuit (100) connected to the current sensor (20) and configured to output an output voltage value (Vo) related to opening and closing of the switch (30, 30A, 30B, 30C) based on a current measured by the current sensor (20),
wherein the overcurrent protection circuit (100) comprises an overcurrent protection unit configured to increase an input voltage value (Vi) according to an input of the current over time, step up the input voltage value (Vi) within a predetermined range in response to the input voltage value (Vi) exceeding a reference voltage value (Vref), and output an output voltage value (Vo) at a first level.

12. The battery (40A, 40B, 40C) module (10A, 10B, 10C) as claimed in claim 11, further comprising a driving circuit (50A, 50B, 50C) connected to the switch (30, 30A, 30B, 30C) to open and close the switch (30, 30A, 30B, 30C).

13. The battery (40A, 40B, 40C) module (10A, 10B, 10C) as claimed in claim 12, wherein the driving circuit (50A, 50B, 50C) is configured to,
obtain the output voltage value (Vo) from the overcurrent protection circuit (100), open the switch (30, 30A, 30B, 30C) in response to the output voltage value (Vo) at the first level, and
close the switch (30, 30A, 30B, 30C) in response to an output voltage value (Vd) at a second level.

14. The battery (40A, 40B, 40C) module (10A, 10B, 10C) as claimed in claim 12 or 13, further comprising:
a controller configured to control the driving circuit (50A, 50B, 50C); and
an OR gate (70) including an input terminal connected to the controller and the overcurrent protection circuit (100) and an output terminal connected to the driving circuit (50A, 50B, 50C).

15. The battery (40A, 40B, 40C) module (10A, 10B, 10C) as claimed in claim 14, wherein the driving circuit (50A, 50B, 50C) is configured to obtain the output voltage value (Vo) at the first level from the overcurrent protection circuit (100) or open the switch (30, 30A, 30B, 30C) in response to receiving an open control signal from the controller.
